(19) Europäisches Patentamt / European Patent Office / Office européen des brevets

(11) **EP 4 396 594 B1**

(12) **FASCICULE DE BREVET EUROPEEN**

(45) Date de publication et mention
de la délivrance du brevet:
**08.10.2025   Bulletin 2025/41**

(21) Numéro de dépôt: **22773282.3**

(22) Date de dépôt: **26.08.2022**

(51) Classification Internationale des Brevets (IPC):
**G01R 31/36** *(2020.01)*      **G01R 31/367** *(2019.01)*
**G01R 31/3832** *(2019.01)*      **G01R 31/387** *(2019.01)*

(52) Classification Coopérative des Brevets (CPC):
**G01R 31/387; G01R 31/3648; G01R 31/367;
G01R 31/3833;** G01R 31/3647

(86) Numéro de dépôt international:
**PCT/FR2022/051614**

(87) Numéro de publication internationale:
**WO 2023/031542 (09.03.2023 Gazette 2023/10)**

(54) **PROCÉDÉ DE SURVEILLANCE D'UN NIVEAU DE CHARGE D'UNE BATTERIE, ET SYSTÈME DE STOCKAGE ASSOCIÉ**

VERFAHREN ZUR ÜBERWACHUNG EINES LADEZUSTANDS EINER BATTERIE UND ZUGEHÖRIGES SPEICHERSYSTEM

METHOD FOR MONITORING A CHARGING LEVEL OF A BATTERY, AND ASSOCIATED STORAGE SYSTEM

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **03.09.2021   FR 2109250**

(43) Date de publication de la demande:
**10.07.2024   Bulletin 2024/28**

(73) Titulaire: **Safran Electrical & Power
31702 Blagnac (FR)**

(72) Inventeur: **SAYEGH, Marie
77550 Moissy-Cramayel (FR)**

(74) Mandataire: **Cabinet Camus Lebkiri
25 rue de Maubeuge
75009 Paris (FR)**

(56) Documents cités:
**EP-A1- 2 019 324      US-A1- 2013 166 119
US-A1- 2015 046 108      US-A1- 2017 242 078
US-A1- 2021 181 259**

**Description**

## DOMAINE TECHNIQUE

Le domaine technique est celui de la surveillance et de la gestion des batteries électriques, en particulier des batteries embarquées dans un véhicule, notamment dans un aéronef.

## ARRIERE-PLAN TECHNOLOGIQUE

Des efforts de développement importants sont en cours pour mettre au point et perfectionner des aéronefs à propulsion électrique ou hybride, du fait de leur intérêt sur un plan environnemental et écologique. Dans de tels aéronefs, la gestion et la surveillance des batteries électriques est particulièrement importante, du fait de leur rôle dans la propulsion de l'aéronef, et cela d'autant que les conditions d'utilisation de ces batteries peuvent rendre difficile la restitution de la charge électrique qui y est stockée (températures de fonctionnement parfois extrêmes, forts appels de courant).

La gestion et la surveillance des batteries électriques est également importante dans un aéronef propulsé par des turboréacteurs, même si ces batteries ne sont pas des batteries de propulsion, car elles alimentent électriquement les instruments et l'électronique de bord (ainsi que certains actionneurs), nécessaires au pilotage de l'aéronef.

La charge électrique stockée dans une batterie, à un instant donné, est souvent représentée par une grandeur appelée état de charge, ou parfois niveau de charge SOC (pour « State of Charge » en anglais). L'état de charge SOC, souvent exprimé comme un pourcentage de la capacité totale de la batterie, est généralement égal au rapport entre, d'une part, une charge emmagasinée dans la batterie à l'instant considéré, et, d'autre part, une charge maximale ou nominale $Q_{max}$ pouvant être stockée dans cette batterie (i.e. : charge emmagasinée divisée par la capacité totale de la batterie).

Une technique connue pour évaluer l'état de charge SOC d'une batterie consiste à mesurer la tension en circuit ouvert $U_o$ aux bornes de la batterie (« Open Circuit Voltage » OCV en anglais), ainsi que la température T de la batterie. Son état de charge SOC est alors déterminé en utilisant un abaque, caractéristique de cette batterie, qui relie l'état de charge SOC à ces deux grandeurs, $U_o$ et T.

Mais, en général, cette technique ne peut être employée que lorsque la batterie ne débite pas de courant électrique.

Lorsque la batterie débite du courant, son état de charge peut être suivi par comptage coulométrique, en mesurant le courant i qu'elle débite et en l'intégrant au cours du temps pour en déduire la charge électrique débitée par la batterie. L'état de charge SOC est alors déterminé conformément à la formule F1 ci-dessous :

$$SOC = SOC_0 - \left( \int i \times dt \right) / Q_{max} \qquad (F1)$$

où $SOC_o$ est un état de charge initial, déterminé comme expliqué plus haut sur la base de la tension en circuit ouvert $U_o$ (à un instant initial pour lequel le courant débité i est nul, ou tout au moins faible).

Un inconvénient de cette méthode est qu'un léger biais ou erreur de calibration du capteur de courant peut finir par entrainer une erreur importante sur l'état de charge SOC estimé, car cette erreur est accumulée au cours du temps, par intégration.

Et surtout, le niveau de charge SOC estimé de cette manière n'est pas directement représentatif de la charge électrique effectivement disponible, c'est-à-dire pouvant effectivement être délivrée par la batterie à l'instant considéré. En effet, dans cette formule, la charge électrique prise en compte est la charge électrique stockée dans la batterie, présente (physiquement) dans celle-ci. Alors que la charge électrique pouvant effectivement être restituée peut-être plus faible que cette charge stockée : selon les conditions de fonctionnement de la batterie (température et courant de décharge notamment), une partie de la charge stockée dans la batterie ne pourra pas en être extraite.

Cet inconvénient se comprend bien en considérant une situation dans laquelle la batterie s'est déchargée jusqu'à atteindre un SOC de 30 %, par exemple. Par la suite, alors que la batterie ne débite pas ou peu, sa température chute brutalement. La valeur du SOC, estimé selon la formule F1, sera alors encore de 50%, alors qu'en fait la batterie se trouve dans une situation où elle ne peut quasiment pas délivrer de courant (du fait de sa température faible).

Pour pallier à ces inconvénients, il a été proposé, par exemple dans le document US6534954, de déterminer un état de charge disponible, représentatif d'une charge *pouvant effectivement être délivrée dans les conditions considérées*, cette détermination étant réalisée sur la base :

- d'une mesure du courant i débité (mesure prise en compte par comptage coulométrique),
- et aussi d'une mesure de la tension électrique U aux bornes de la batterie (pas nécessairement une tension en circuit ouvert) et de sa température T,

- ces mesures étant prises en compte par l'intermédiaire d'un observateur d'état, par exemple de type filtre de Kalman (le courant étant pris en compte lors de l'étape de prédiction, c'est-à-dire d'évolution, tandis que la tension et la température sont prises en compte, via un modèle de fonctionnement de batterie, lors de l'étape de mise à jour, c'est-à-dire de recalage du filtre).

Mais les calculs nécessaires pour estimer de cette manière un état de charge disponible de la batterie sont très volumineux (comme souvent lorsqu'on a recours à un filtre de Kalman). De plus, le réglage des paramètres du filtre (valeur des gains de rétroaction, ou « gains de Kalman », par exemple, qui sont recalculés à chaque pas de temps) reste généralement assez empirique, et ne garantit pas forcément une estimation optimale de l'état de charge.

Le document US 2015/046108 A1 divulgue un procédé de surveillance d'un niveau de charge d'une batterie comprenant des étapes de: mesure d'un courant électrique délivré par la batterie, mesure d'une température de la batterie et le calcul d'une charge électrique totale emmagasinée dans la batterie par comptage coulométrique.

**RESUME**

Dans ce contexte, on propose un procédé de surveillance d'un niveau de charge d'une batterie d'accumulateurs électriques, le procédé comprenant des étapes de :

- mesure d'un courant électrique délivré par la batterie,
- mesure d'une température de la batterie,
- calcul, par un système électronique de traitement et de contrôle, d'une charge électrique totale emmagasinée dans la batterie à un instant courant, par comptage coulométrique, en fonction d'une charge électrique totale emmagasinée dans la batterie à un instant précédent et en fonction du courant électrique mesuré,
- calcul d'un état de charge stockée, égal à la charge électrique totale emmagasinée dans la batterie à l'instant courant, divisée par une charge totale maximale pouvant être emmagasinée dans la batterie, calcul d'une charge électrique disponible en fonction d'une différence entre (par exemple égale à la différence entre)

  - la charge électrique totale emmagasinée dans la batterie à l'instant courant, et

  - une charge électrique non extractible, ne pouvant pas être extraite de la batterie compte tenu de sa température, la charge électrique non extractible étant déterminée en fonction au moins de ladite température mesurée, à partir de caractéristiques de fonctionnement de la batterie stockées dans une mémoire du système électronique de traitement et de contrôle,

- calcul d'un état de charge disponible, égal à la charge électrique disponible, divisée par une charge disponible maximale, la charge disponible maximale étant égale à la différence entre, d'une part, une charge maximale atteignable, pouvant être emmagasinée au maximum dans la batterie lorsqu'elle est chargée à ladite température, et d'autre part, ladite charge électrique non extractible.

La charge totale maximale pouvant être emmagasinée dans la batterie, mentionnée ci-dessus, est par exemple la charge pouvant être stockée, au maximum, dans la batterie, pour des conditions de charge optimales, ou pour des conditions de charge nominales.

La charge maximale atteignable est déterminée elle aussi, comme la charge non extractible, en fonction au moins de ladite température mesurée, à partir desdites caractéristiques de fonctionnement de la batterie.

Dans ce procédé, au lieu de déterminer directement l'évolution un niveau de charge disponible, en prenant en compte en même temps la charge électrique débitée et les conditions de fonctionnement de batterie de manière couplée, on calcule de manière séparée :

- l'évolution de la charge électrique présente dans la batterie (charge électrique totale, emmagasinée dans la batterie), et
- l'influence des conditions de fonctionnement en cours (notamment de la température) sur la charge électrique pouvant effectivement être restituée (charge disponible).

*Ce découplage* entre l'évolution de la charge électrique d'une part, et la prise en compte des conditions de restitution de cette charge d'autre part, *simplifie nettement les calculs* par rapport à l'estimation basée sur un filtre de Kalman présentée plus haut. En effet, chacune de ces deux opérations est peu couteuse en elle-même, en termes de calcul.

En effet, un comptage coulométrique seul nécessite peu de calcul, en lui-même. Et pour ce qui est de l'influence des conditions de fonctionnement sur la charge électrique pouvant effectivement être restituée, elle peut par exemple estimée grâce à une table de correspondance ou une formule numérique reliant la charge électrique effectivement stockée à la charge électrique disponible, pour différentes conditions de fonctionnement, ce lien ayant par exemple déterminé lors de tests préalables de charge restituée (décrits plus bas). Le calcul en question est donc lui aussi peu couteux.

Cette manière d'estimer l'état de charge disponible a par ailleurs l'avantage d'être robuste (à nouveau, grâce au découplage en question). En effet, au cours de ce procédé, on conserve telle qu'elle la donnée relative à la charge électrique totale stockée dans la batterie, donnée qui présente un degré de fiabilité élevé en termes de suivi de charge (puisqu'il s'agit de la charge électrique présente effectivement, physiquement dans la batterie). Alors que dans la méthode basée sur un filtre de Kalman qui a été présentée en préambule, on perd progressivement cette information, car la charge électrique stockée est corrigée, en quelque sorte hybridée en continu avec les conditions de restitution de cette charge (cet inconvénient se rencontre d'ailleurs aussi dans d'autres méthodes classiques, sans filtre de Kalman, dans lesquelles la variation de charge par comptage coulométrique, et l'influence des conditions de fonctionnement, sont prises en compte simultanément, en quelque sorte de manière couplée).

Par ailleurs, les deux états de charge déterminés lors de ce procédé, à savoir l'état de charge stockée et état de charge disponible, fournissent tous deux des informations très utiles et complémentaires. Il est donc particulièrement intéressant d'estimer ainsi ces deux grandeurs, plutôt qu'une seule.

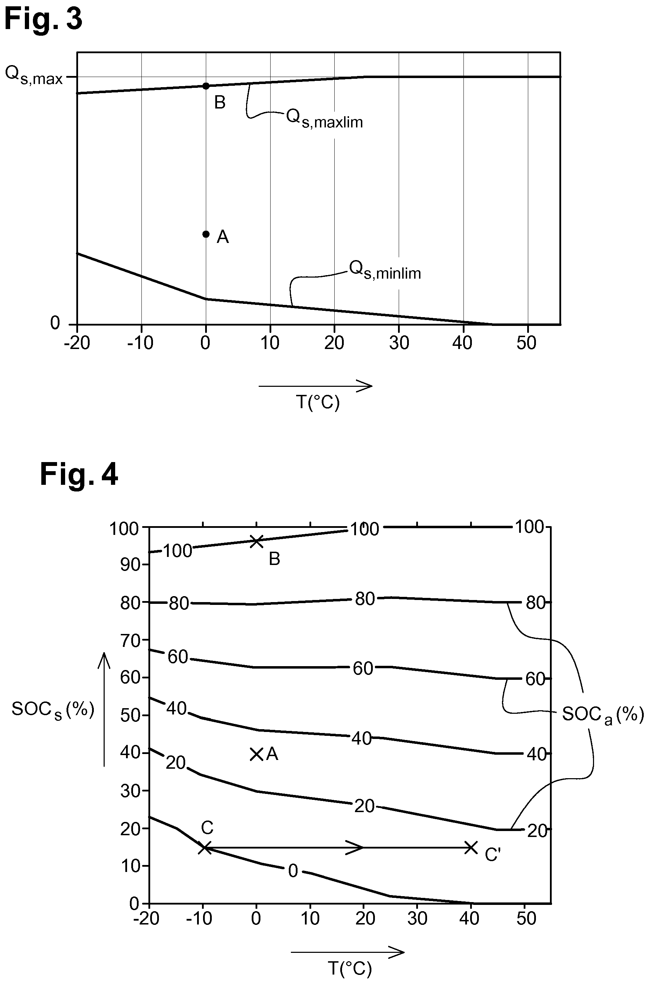

En effet, *l'état de charge stockée* renseigne sur la charge présente dans la batterie, indépendamment des conditions de fonctionnement. A lui seul, cet état de charge n'est pas suffisant pour surveiller (et piloter) la batterie, puisque la charge effectivement disponible peut s'avérer nettement plus faible que celle indiquée par cet état de charge, selon les conditions de fonctionnement à l'instant considéré (cette situation correspond par exemple au point A, sur la figure 4). Cet indicateur reste toutefois intéressant, justement parce qu'il permet d'éviter une variabilité due aux changements possibles des conditions de fonctionnement (pour un utilisateur, voir un état de charge varier alors qu'il n'utilise pas la batterie peut être une source de confusion, et il est donc intéressant qu'il dispose d'un indicateur « stable » tel que cet état de charge stockée).

Quant à *l'état de charge disponible*, il fournit une indication facilement interprétable, représentative de la charge immédiatement disponible, compte tenu des conditions de fonctionnement en cours. Mais justement, comme les conditions de fonctionnement sont susceptibles de changer (ou d'être ajustées, en pilotant la batterie), il est utile de disposer aussi d'une information sur la charge (en quelque sorte absolue) stockée dans la batterie, indépendamment de ces conditions de fonctionnement (information qui est fournie par *l'état de charge stockée*).

A titre d'exemple, l'utilisation combinée de l'état de charge disponible et de l'état de charge stockée permet de détecter une situation dans laquelle la charge immédiatement disponible est faible, alors que la charge stockée est en fait relativement élevée. Dans cette situation, il peut être plus adapté de commander un chauffage de la batterie (et/ou une redistribution du courant total à fournir, entre différentes batteries d'un aéronef), plutôt que d'amorcer d'une phase de descente de l'aéronef équipé de cette batterie.

Dans la présente demande, l'expression « charge électrique », et l'expression « charge » sont employées indifféremment.

Les étapes de calcul présentées ci-dessus sont exécutées par le système électronique et de traitement et de contrôle, qui a la structure d'un calculateur, ou ordinateur.

Outre les caractéristiques présentées ci-dessus, le procédé présenté ci-dessus peut présenter une ou plusieurs des caractéristiques optionnelles suivantes, considérées individuellement ou selon toutes les combinaisons techniquement envisageables :

- la charge électrique non extractible est déterminée en fonction en outre du courant électrique mesuré, la charge électrique non extractible étant une charge électrique ne pouvant pas être extraite de la batterie lorsqu'elle a une température égale à ladite température mesurée et qu'elle délivre un courant égal audit courant électrique mesuré ;

- la charge maximale atteignable est déterminée en fonction de ladite température et du courant électrique mesuré, la charge maximale atteignable étant une charge électrique pouvant être emmagasinée au maximum dans la batterie lorsque la batterie est chargée à une température égale à la température mesurée et avec un courant de charge égal, en valeur absolue, au courant électrique mesuré ;

- le procédé comprend une étape préliminaire de caractérisation de la batterie, au cours de laquelle une partie au moins des caractéristiques de fonctionnement de la batterie sont déterminées en effectuant des essais de charge et de décharge sur une batterie de test du même modèle que ladite batterie, ou sur une cellule de test d'une telle batterie de test ;

- au cours de l'étape préliminaire de caractérisation, pour déterminer la charge électrique non extractible à une température de test donnée, on réalise les opérations suivantes, sur la batterie de test ou sur la cellule de test :

- Charge de la batterie ou de la cellule de test, puis

- A ladite température de test, première décharge de la batterie ou de la cellule de test jusqu'à atteindre, aux bornes de la batterie ou de la cellule de test, une tension électrique de seuil de fonctionnement, puis

- Modification de la température de la batterie ou de la cellule de test pour l'amener à une température de fonctionnement optimale, puis

- A la température de fonctionnement optimale, deuxième décharge de la batterie ou de la cellule de test, en comptabilisant la charge électrique qui est délivrée jusqu'à ce que la tension aux bornes de la batterie ou de la cellule de test atteigne ladite tension électrique de seuil de fonctionnement, la charge électrique non extractible à ladite température de test étant déterminée à partir de la charge électrique délivrée comptabilisée lors de cette deuxième décharge ;

- les caractéristiques de fonctionnement de la batterie comprennent une table de correspondance mettant au moins en correspondance des valeurs de température de la batterie avec des valeurs correspondantes de charge électrique non extractible, ainsi qu'avec des valeurs correspondantes de charge maximale atteignable ;

- les caractéristiques de fonctionnement de la batterie comprennent une première formule de calcul numérique reliant au moins la charge électrique non extractible à la température de la batterie, et une deuxième formule de calcul numérique reliant la charge électrique maximale atteignable à la température de la batterie, la première et la deuxième formule étant paramétrées chacune par des coefficients dont les valeurs sont caractéristiques de ladite batterie ;

- au cours du procédé, une interface homme-machine indique ledit état de charge disponible et ledit état de charge stockée ;

- la batterie et le système électronique de traitement et de contrôle équipent un véhicule, par exemple un aéronef, et le système électronique de traitement et de contrôle :

  - détermine une préconisation de pilotage en fonction de l'état de charge disponible et de l'état de charge stockée, et

  - commande à ladite interface homme-machine d'indiquer ladite préconisation de pilotage et/ou commande un ou plusieurs actionneurs du véhicule pour piloter le véhicule conformément à ladite préconisation de pilotage ;

- lorsqu'une condition prédéterminée portant à la fois sur l'état de charge stockée et sur l'état de charge disponible est remplie, le système électronique de traitement et de contrôle commande :

  - une modification de température de la batterie, et/ou

  - une modification d'une répartition, entre plusieurs batteries d'un ensemble de batteries auquel appartient ladite batterie, d'un courant électrique total à délivrer.

La présente technologie concerne aussi un système de stockage d'électricité comprenant une batterie d'accumulateurs électriques, un capteur de température agencé pour mesurer une température de la batterie, un capteur de courant mesurant le courant électrique délivré par la batterie, et un système électronique de traitement et de contrôle comportant au moins un processeur et une mémoire, le système électronique de traitement et de contrôle étant configuré pour exécuter les étapes suivantes :

- calculer une charge électrique totale emmagasinée dans la batterie à un instant courant, par comptage coulométrique, en fonction d'une charge électrique totale emmagasinée dans la batterie à un instant précédent et en fonction d'un courant électrique mesuré par le capteur de courant,

- calculer un état de charge stockée, égal à la charge électrique totale emmagasinée dans la batterie à l'instant courant, divisée par une charge totale maximale pouvant être emmagasinée dans la batterie,

- calculer une charge électrique disponible en fonction d'une différence entre,

  - la charge électrique totale emmagasinée dans la batterie à l'instant courant, et

  - une charge électrique non extractible, ne pouvant pas être extraite de la batterie compte tenu de sa température, la charge électrique non extractible étant déterminée en fonction au moins de la température mesurée par ledit capteur de température, et à partir de caractéristiques de fonctionnement de la batterie stockées dans la mémoire du système électronique de traitement et de contrôle :

- calculer un état de charge disponible, égal à ladite charge électrique disponible, divisée par une charge disponible maximale, la charge disponible maximale étant égale à la différence entre, d'une part, une charge maximale atteignable, pouvant être emmagasinée au maximum dans la batterie lorsqu'elle est chargée à ladite température, et d'autre part, ladite charge électrique non extractible.

Le système électronique de traitement et de contrôle est configuré pour acquérir la valeur de la température en question, mesurée par le capteur de température, et pour acquérir la valeur du courant électrique i mesuré par le capteur de courant.
Les caractéristiques complémentaires présentées ci-dessus en termes de procédé peuvent aussi s'appliquer au système de stockage qui vient d'être décrit.
La présente technologie concerne aussi un véhicule, en particulier un aéronef, comprenant un tel système de stockage d'électricité.
La présente technologie et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif.

[Fig. 1] La figure 1 représente schématiquement un aéronef équipé d'un système de stockage d'électricité basé sur la présente technologie.

[Fig. 2] La figure 2 représente schématiquement des étapes d'un procédé de surveillance d'une batterie électrique du système de stockage de la figure 2.

[Fig. 3] La figure 3 représente schématiquement l'évolution, en fonction de la température, d'une charge électrique non extractible et d'une charge maximale atteignable, pour la batterie en question.

[Fig. 4] La figure 4 représente l'évolution d'un état de charge disponible de cette batterie, en fonction d'un état de charge stockée et de la température.

## DESCRIPTION DETAILLEE

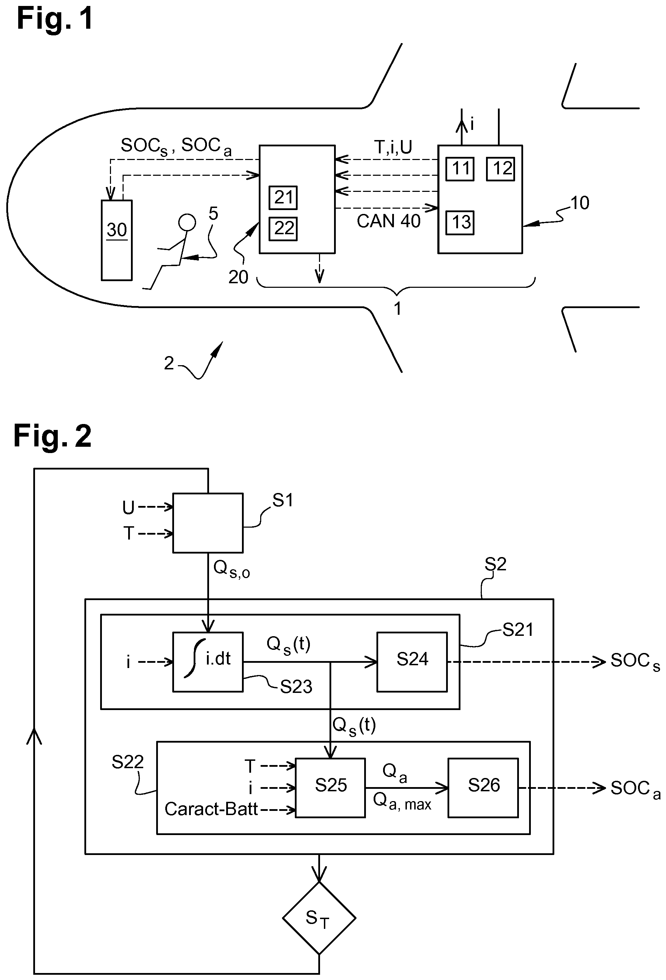

Comme indiqué dans la partie intitulée « résumé », la présente technologie concerne un système de stockage d'électricité, 1 (figure 1), et un procédé associé de surveillance d'un niveau de charge (de l'état plus ou moins chargé, ou, autrement dit, du caractère plus ou moins chargé) d'une batterie 10 d'accumulateurs électriques de ce système de stockage (figure 2). Au cours de ce procédé, il est prévu de déterminer :

- un état de charge stockée $SOC_s$ (avec l'indice « s » pour « stored » c'est-à-dire « stockée » en anglais), déterminé directement à partir d'une charge électrique totale $Q_s$ emmagasinée dans la batterie 10 (indépendamment des conditions dans lesquelles la batterie débite), et

- un état de charge disponible $SOC_a$ (avec l'indice « a » pour « available », c'est-à-dire « disponible » en anglais), basé sur une charge électrique disponible $Q_a$ pouvant effectivement être extraite de la batterie 10, compte tenu des conditions dans lesquelles la batterie débite (condition de température et de courant notamment).

La structure générale du système de stockage est décrite tout d'abord. Le procédé en question, et des exemples d'utilisation de ce couple particulier d'états de charge sont présentés ensuite.

Système de stockage d'électricité

La figure 1 représente schématiquement ce système de stockage 1, qui, en l'occurrence, équipe un aéronef 2, ici un aéronef à voilure fixe.

Le système de stockage 1 comprend la batterie 10 d'accumulateurs électriques, destinée à alimenter des équipements électriques de l'aéronef. Ces équipements peuvent être des équipements de propulsion, tels que des propulseurs électriques à hélice, ou des équipements de pilotage, tel qu'une unité électronique de pilotage ou un actionneur de contrôle d'attitude de l'aéronef (par exemple un actionneur de contrôle d'aileron, tel qu'un vérin électrique).

Différents types de technologie de batterie sont envisageables pour la batterie 10, en particulier en ce qui concerne le matériau ou ensemble de matériaux de base à partir duquel la batterie 10 est réalisée (par exemple du plomb, ou du Nickel et du Cadmium, ou du Lithium et du Cobalt et du Manganèse). Et différents types d'anode ou cathode peuvent être employés (par exemple, si la batterie 10 est une batterie au Lithium, il peut s'agir d'anodes en graphite ou en Titanate de Lithium « LTO », et de cathodes en Phosphate de Fer Lithié « LFP » ou Oxyde de Cobalt-Lithium-Manganèse-Nickel « NMC », par exemple).

Par ailleurs, la batterie 10 peut, comme ici, comprendre plusieurs cellules électrochimiques connectées électriquement en séries les unes avec les autres (pour atteindre une tension suffisamment élevée) et/ou en parallèle (pour atteindre les niveaux de puissance requis). La batterie 10 peut aussi comprendre plusieurs accumulateurs, connectés en série et/ou en parallèle, chaque accumulateur regroupant plusieurs cellules.

Le système de stockage 1 comprend aussi :

- un capteur de courant 11, pour mesurer un courant électrique i délivré par la batterie ; ce courant est le courant électrique total débité par la batterie ; il est positif lorsque la batterie débite, et négatif lorsqu'elle se charge ; le capteur de courant est par exemple un ampèremètre numérique connectée en sortie de la batterie (il peut par exemple s'agir d'une pince ampèremétrique avec capteur à effet Hall, ou d'un dispositif la tension électrique aux bornes d'une très faible résistance de shunt traversée par le courant i);

- un capteur de température 12 (réalisé par exemple à partir de thermocouples, ou de thermistances), pour mesurer la température T de la batterie 10 ; et

- un capteur de tension électrique 13 (de type voltmètre numérique), pour mesurer la tension électrique, U, entre les bornes de sortie de la batterie 10.

Ces capteurs, qui fournissent des informations sur les conditions de fonctionnement de la batterie 10, peuvent être intégrés à la batterie 10 ou être montés extérieurement à celle-ci.

Le système de stockage 1 comprend aussi un système électronique de traitement et de contrôle, 20. Le système de traitement et de contrôle 20 a notamment pour fonction de surveiller l'état de la batterie 10, en déterminant les états de charge $SOC_s$ et $SOC_a$ mentionnés plus haut.

Le système de traitement et de contrôle 20 a la structure d'un calculateur (en l'occurrence un calculateur de bord), ou, autrement formulé, d'un ordinateur. Il comprend un circuit électronique (en une ou plusieurs parties) équipé au moins d'une mémoire 22 de type non-volatile, et d'un processeur 21 permettant d'exécuter des opérations logiques. Il peut comprendre aussi une ou plusieurs autres mémoires (non représentées), de type mémoire vive (RAM) ou d'un autre type, et un ou plusieurs autres processeurs.

Ici, le système de traitement et de contrôle 20 comprend plusieurs unités électroniques (ou ECU, pour « Electronic Control Unit » en anglais) différentes. Chacune de ces unités électroniques (i.e. : chacun de ces modules) est un calculateur configuré pour surveiller, contrôler et/ou piloter un ou des organes de l'aéronef 2. Le système de traitement et de contrôle 20 comprend notamment une unité de contrôle électronique de type BMU (pour « Battery Management Unit » en anglais), pour surveiller la batterie 10, et, de manière optionnelle, pour la piloter. Il comprend aussi une unité électronique configurée pour piloter une interface homme-machine 30. L'interface homme-machine 30, qui comprend des afficheurs et des organes de commande, permet à un pilote 5 de l'aéronef de surveiller les paramètres de vol et de fonctionnement de l'aéronef, et elle lui permet aussi de piloter des organes de propulsion et de direction de cet aéronef. Le système de traitement et de contrôle 20 comprend aussi une unité électronique configurée pour commander un ou plusieurs des organes de propulsion ou de direction de l'aéronef, afin de modifier ses paramètres de vol. Ces différentes unités électroniques sont connectées les unes aux autres, de manière à pouvoir échanger des données (et éventuellement des instructions). Chacune des unités électroniques en question peut être réalisée sous la forme d'un circuit électronique comprenant par exemple un microcircuit programmable (par exemple de type FPGA - pour « Field Programmable Gate Array » en anglais).

En variante, le système de traitement et de contrôle en question pourrait comprendre seulement la BMU mentionnée ci-dessus. En variante encore, au lieu de comprendre plusieurs unités électroniques distinctes, le système de traitement et de contrôle pourrait prendre la forme d'une même unité électronique commune, exécutant les différentes fonctions mentionnées ci-dessus.

Les capteurs 11, 12, 13 sont reliés au système de traitement et de contrôle 20 de manière à pouvoir transmettre à ce système des données représentatives du courant i, de la température T et de la tension U mesurés. Ces données sont par exemple transmises de l'un à l'autre par l'intermédiaire d'un bus de données 40, par un bus de type CAN (pour « Controller Area Network » en anglais).

Le système de traitement et de contrôle 20 est configuré, par exemple programmé (grâce à des instructions stockées dans la mémoire 22, ou en configurant un circuit à portes logiques reconfigurable) pour exécuter les étapes du procédé de surveillance qui sont représentées sur la figure 2.

Procédé de surveillance de l'état plus ou moins chargé de la batterie

Ce procédé comprend une détermination des états de charge de la batterie $SOC_s$ et $SOC_a$ mentionnés plus haut. Cette détermination est effectuée par le système de traitement et de contrôle 20, qui est configuré pour acquérir les valeurs de courant, de température et de tension mesurées par les capteurs 11, 12, 13, et pour calculer les états de charge $SOC_s$ et $SOC_a$ sur cette base (figure 2).

La façon de déterminer ces deux états de charge est décrit tout d'abord. Différentes utilisations possibles de ce couple d'état de charge (utilisations qui font partie du procédé en question), sont présentées ensuite.

Le procédé en question peut aussi comprendre une étape préliminaire de caractérisation de la batterie 10 (étape non représentée sur les figures), au cours de laquelle des caractéristiques de fonctionnement Caract_Batt de la batterie 10 sont déterminées, en effectuant des essais de charge et de décharge sur une batterie de test du même modèle que ladite batterie 10, ou sur une cellule de test d'une telle batterie de test. Cette étape préliminaire sera décrite dans un deuxième temps.

Au cours de ce procédé, la charge électrique totale $Q_s$ emmagasinée dans la batterie 10 est déterminée par comptage coulométrique, à partir du courant électrique i mesuré par le capteur de courant 13.

Pour cela, une charge initiale $Q_{s,o}$, emmagasinée dans la batterie 10 à un instant d'initialisation $t_o$, est déterminée tout d'abord lors d'une étape d'initialisation S1 (voir la figure 2). Au cours de cette étape, la charge initiale $Q_{s,o}$ est calculée en fonction :

- de la tension électrique U aux bornes de la batterie 10, mesurée de préférence à vide (i.e. : à un moment où le courant débité i est nul), et

- de sa température T,

- et sur la base d'un modèle de fonctionnement de la batterie, dont les caractéristiques (lien entre charge stockée, tension et température) sont par exemple stockées dans la mémoire 22.

Ce modèle de fonctionnement peut par exemple être déterminé au préalable, en réalisant des mesures lors de l'étape préliminaire mentionnée plus haut. La détermination de la charge initiale $Q_{s,o}$ en elle-même ne constitue pas le cœur de l'innovation présentée ici, et elle ne sera donc pas décrite plus avant.

Le procédé comprend ensuite une étape S2 de calcul des états de charge $SOC_s$ et $SOC_a$. Cette étape comprend :

- une étape S21, qui comprend le calcul de la charge totale emmagasinée, $Q_s$ (lors d'une étape de comptage S23) et le calcul de l'état de charge stockée $SOC_s$ (étape S24), et

- une étape S22, qui comprend le calcul de la charge disponible $Q_a$ (lors d'une étape S25) et celui de l'état de charge disponible $SOC_a$ (lors d'une étape S26).

Lors de l'étape de comptage S23, la charge totale $Q_s$ est calculée, par comptage coulométrique, sur la base du courant i mesuré, et avec la charge initiale $Q_{s,o}$ comme point de départ. La charge totale $Q_s$ est ainsi calculée conformément à la formule F2 suivante :

$$Q_s = Q_{s,0} - \int i \times dt \qquad (F2)$$

Ce calcul est réalisé en continu, c'est-à-dire que la valeur de la charge totale $Q_s$ emmagasinée dans la batterie est mise à jour à chaque nouveau de pas de temps (sur la base du courant i mesuré au pas de temps considéré). Autrement formulé, le courant i est intégré en continu, au cours du temps t. Cela permet de connaitre la charge totale $Q_s(t)$ emmagasinée dans la batterie à chaque pas de temps (à chaque instant t).

L'état de charge stockée $SOC_s$ est calculé, à chaque pas de temps, en divisant la charge totale $Q_s$ par une charge totale maximale $Q_{s,max}$ pouvant être emmagasinée dans la batterie 10 :

$$SOC_s = Q_s / Q_{s,\max} \qquad (F3)$$

La charge totale maximale $Q_{s,max}$ est une charge totale pouvant être stockée dans la batterie dans des conditions de charge favorables, voire optimales, en termes de fonctionnement, pour la batterie. Ces conditions de charge peuvent correspondre à des conditions de fonctionnement nominales, recommandée pour cette batterie 10, par son fabriquant, en termes de température et de courant débité ou reçu (conditions de fonctionnement pour lesquelles la batterie a été conçue).

Ici, la charge totale maximale $Q_{s,max}$ est égale plus précisément à la charge pouvant être emmagasinée au maximum dans la batterie électrique (en partant d'une situation dans laquelle la batterie est entièrement déchargée) lorsque sa température est égale à une température optimale de fonctionnement $T_{opt}$ (la température pour laquelle la charge totale pouvant être emmagasinée est la plus grande). En termes de courant, la charge de la batterie jusqu'à la charge totale maximale $Q_{s,max}$ se fait ici en deux étapes. Une première étape est réalisée avec un courant de charge constant $i_{opt}$ (courant de charge optimale) jusqu'à atteindre la tension limite de fonctionnement. Puis, une deuxième étape de charge est réalisée à tension constante, la tension aux bornes de la batterie étant maintenue égale à la tension limite atteinte précédemment, tout en continuant à charger la batterie jusqu'à ce que le courant de charge devienne très faible, voire nul.

En pratique, la température optimale de fonctionnement $T_{opt}$ peut correspondre à une température modérée (ni trop basse, ni trop élevée), comprise par exemple entre 20 et 50 degrés Celsius dans le cas d'une batterie au Lithium), ou correspondre éventuellement à une température légèrement plus élevée, selon le type de technologie employée pour la batterie. Quant au courant de charge optimal $i_{opt}$, il peut correspondre à un courant d'intensité réduite, pour lequel une charge complète de la batterie prend par exemple 5 heures au moins.

La charge totale maximale $Q_{s,max}$ peut par exemple être égale à une capacité de charge nominale, prévue pour cette batterie par son fabriquant lorsque les conditions de fonctionnement sont optimales (cette capacité nominale étant par exemple indiquée par le fabriquant de la batterie, parmi les différentes spécifications de la batterie).

Lors de l'étape S25, le système de traitement et de contrôle 20 détermine la charge électrique non extractible $Q_{s,minlim}$, emmagasinée dans la batterie 10 mais ne pouvant pas être extraite de la batterie compte tenu de sa température T et du courant i débité par la batterie.

La charge électrique non extractible $Q_{s,minlim}$ est déterminée en fonction de la température T et du courant i, à partir de caractéristiques de fonctionnement Caract_Batt de la batterie stockées dans la mémoire 22 du système de traitement et de contrôle 20.

Ces caractéristiques de fonctionnement Caract_Batt, qui peuvent prendre la forme d'une table de correspondance (de type LUT), ou la forme de formules de calcul numérique, relient des valeurs de température et de courant débité avec des valeurs de charge électrique non extractible Qs,miniim correspondant à ces conditions de température et de courant.

Les caractéristiques de fonctionnement Caract_Batt relient également les valeurs de température et de courant en question à des valeurs de charge maximale atteignable Qs,maxiim. La charge maximale atteignable Qs,maxiim est la charge jusqu'à laquelle on peut charger la batterie 10 lorsqu'elle est à la température T et lorsqu'elle est chargée sous un courant électrique de charge qui, en valeur absolue, est égal à i.

Les caractéristiques de fonctionnement Caract_Batt peuvent être obtenues, lors d'une étape préliminaire de test (décrite plus bas), en cartographiant les performances attendues pour la batterie pour différentes conditions de fonctionnement.

La figure 3 représente, l'évolution de la charge maximale atteignable $Q_{s,maxlim}$ et de la charge non extractible $Q_{s,minlim}$ (exprimées en Ampères.heures), en fonction de la température de fonctionnement T (exprimée en degrés Celsius), pour un exemple de batterie pouvant être employée dans le système de stockage d'énergie de la figure 1, et pour une valeur typique de courant i (en d'autres termes, il s'agit d'une coupe, à i constant, de la cartographie de $Q_{s,minlim}(T,i)$ et de $Q_{s,maxlim}(T,i)$). En l'occurrence, il s'agit d'une valeur modérée de courant.

Pour cet exemple, la charge non-extractible $Q_{s,minlim}$ diminue (ce qui est favorable, en termes de fonctionnement) lorsque la température T augmente, et devient quasiment nulle lorsque la température T est supérieure ou égale à 40 degrés Celsius environ. En revanche, pour des températures inférieures à 0 degrés Celsius environ, la charge non-extractible $Q_{s,minlim}$ prend des valeurs importantes, pouvant atteindre un quart de la capacité totale de la batterie (aux alentours de -20 degrés Celsius), ce qui montre bien l'intérêt qu'il y a à tenir compte de cette charge non extractible.

Pour ce qui est de la charge maximale atteignable Qs,maxiim, jusqu'à 25 degrés Celsius environ, elle augmente légèrement avec la température, pour atteindre une valeur proche de la charge totale maximale $Q_{s,max}$ de la batterie (capacité totale de la batterie), et elle est ensuite constante.

Une fois la charge électrique non extractible $Q_{s,minlim}$ déterminée, le système de traitement et de contrôle 20 calcule la charge électrique disponible $Q_a$ comme étant égale à la différence entre la charge totale $Q_s$ stockée dans la batterie, et la charge électrique non extractible $Q_{s,minlim}$, ne pouvant être extraite de celle-ci dans les conditions considérées :

$$Q_a = Q_s - Q_{s,minlim} \qquad (F4)$$

Lors de l'étape S25, le système de traitement et de contrôle 20 détermine aussi la charge maximale atteignable Qs,maxiim correspondant aux conditions de fonctionnement considérées (sur la base des caractéristiques de fonctionnement Carract_Batt), et calcule une charge disponible maximale $Q_{a,max}$, égale à la différence entre charge maximale atteignable $Q_{s,maxlim}$ et la charge électrique non extractible Qs,miniim :

$$Q_{a,max} = Q_{s,maxlim} - Q_{s,minlim} \qquad (F5)$$

Ensuite, à l'étape S26, le système de traitement et de contrôle 20 calcule l'état de charge disponible $SOC_a$ en calculant le rapport entre la charge disponible $Q_a$ et disponible maximale $Q_{a,max}$ :

$$SOC_a = Q_a/Q_{a,max} \qquad (F6)$$

Comme expliqué dans la partie intitulée « résumé », le fait de découpler ainsi l'évolution de la charge électrique stockée $Q_s$, présente dans la batterie, et l'influence des conditions de fonctionnement en cours sur la charge électrique disponible $Q_a$ pouvant effectivement être restituée, permet de simplifier nettement les calculs, et conduit à une estimation fiable de la charge disponible.

Par ailleurs, les deux états de charge estimés, $SOC_s$ et $SOC_a$, fournissent tous deux des informations utiles et complémentaires concernant la charge électrique susceptible d'être récupérée.

La figure 4 représente schématiquement des valeurs de l'état de charge disponible $SOC_a$ correspondant à différentes valeurs de l'état de charge stockée $SOC_s$, et cela pour différentes valeurs de la température T. Sur ce graphique, la valeur indiquée en un point donnée du graphique (sous forme de lignes de niveaux) est la valeur de l'état de charge disponible $SOC_a$ pour la température indiquée en abscisses, et pour l'état de charge stockée $SOC_s$ indiqué en ordonnées.

Comme on peut le voir sur cette figure, la valeur de l'état de charge disponible $SOC_a$ est souvent nettement différente de la valeur de l'état de charge stockée $SOC_s$, ce qui illustre le caractère complémentaire de ces deux paramètres.

A titre d'exemple, pour le point A représenté sur la figure 4 (et sur la figure 3), pour lequel T=0°C, on a $SOC_s = 40\%$ environ, alors que le SOC disponible $SOC_a$ est en fait de 30% seulement. Cela illustre bien que l'état de charge stockée $SOC_s$ ne fournit pas, à lui seul, une information suffisante pour surveiller l'état de charge de la batterie.

Dans la situation correspondant au point B, pour lequel T=0°C, on a au contraire $SOC_a$=100% alors qu'en fait une charge électrique supplémentaire pourrait être encore être emmagasinée dans la batterie (voir la figure 3), comme indiqué d'ailleurs par l'état de charge stockée $SOC_s$ (qui vaut alors 95% environ).

Et dans la situation correspondant au point C, pour lequel T=-10°C, on a $SOC_a$=0% alors qu'en fait une charge électrique non nulle est stockée dans la batterie ($SOC_s = 15\%$ environ), mais est non-disponible. Dans une telle situation, au vu des valeurs de $SOC_a$ et de $SOC_s$, il peut être intéressant de commander un chauffage de la batterie pour faire augmenter sa température (par exemple jusqu'au point C', pour lesquel T=40°C, $SOC_s$ restant égal à 15%, tandis que l'état de charge disponible passe de 0% à 12% environ).

Ces différents exemples montrent bien l'intérêt de connaitre à la fois l'état de charge stockée, et l'état de charge disponible.

Enfin, comme illustré sur la figure 2, il est prévu dans ce procédé de réinitialiser les valeurs des états de charge $SOC_a$ et $SOC_s$, par exemple à intervalle régulier, pour limiter l'influence d'éventuels biais ou erreurs de mesure du courant i (qui, en étant accumulés au cours du temps, finiraient par fausser l'estimation par comptage coulométrique).

Pour cela, lorsqu'une condition de réinitialisation est vérifiée (condition qui est testée à l'étape $S_T$), l'exécution de l'étape S2 est stoppée et le procédé reprend en exécutant à nouveau l'étape d'initialisation S1 (puis, à nouveau, l'étape S2). Comme indiqué plus haut, lors de l'étape S1, la charge contenue dans la batterie est estimée directement sur la base de la tension en circuit ouvert $U_o$ aux bornes de la batterie (et en tenant compte de la température T de la batterie).

Cette condition de réinitialisation peut porter sur une durée écoulée depuis le dernier instant d'utilisation de la batterie : lorsque cette durée devient supérieure à une durée seuil donnée (durée seuil comprise par exemple entre 15 minutes et 3 heures), l'étape d'initialisation S1 est exécutée à nouveau. Par dernier instant d'utilisation de la batterie, on entend le dernier instant pour lequel un courant substantiel a été débité (ou reçu) par la batterie, le courant débité étant ensuite nul ou très faible, par exemple inférieur à un seuil représentatif d'une erreur de mesure pour le courant i. De manière optionnelle, le système de traitement et de contrôle peut être configuré pour permettre aussi un déclenchement manuel de cette réinitialisation, par un opérateur (en plus de la réinitialisation à intervalle régulier mentionnée ci-dessus). La condition de réinitialisation en question pourrait aussi, en variante ou en complément, correspondre à la détection d'une anomalie dans l'estimation de l'un des états de charge $SOC_a$ et $SOC_s$.

Au cours de ce procédé, la valeur de l'état de charge disponible $SOC_a$ est indiquée par l'interface homme-machine 30 (le système de traitement et de contrôle 20 commande à cette interface d'indiquer cette valeur), par exemple au moyen d'un écran d'affichage permettant d'afficher des données ou images représentatives de cet état de charge, ou au moyen d'un indicateur analogique, par exemple à aiguille. La valeur de l'état de charge stockée $SOC_s$ peut aussi, comme ici, être indiquée par l'interface homme-machine 30. Ces valeurs sont mises à jour en continu, à chaque nouvelle évaluation de ces états de charge.

Par ailleurs, au cours de procédé, le système de traitement et de contrôle 20 teste régulièrement si une condition prédéterminée, portant à la fois sur l'état de charge stockée $SOC_s$ et sur l'état de charge disponible $SOC_a$, indique un état de charge disponible faible (par exemple inférieur à 20%, ou même à 10 ou 5%) alors que l'état de charge stockée est relativement élevé (par exemple supérieur à 20 ou à 30%). Lorsque cette condition est remplie, le système de traitement et de contrôle 20 peut par exemple commander une modification de température de la batterie 10, en commandant un système de chauffage de la batterie pour augmenter sa température (si elle est basse, par rapport à la température optimale de fonctionnement $T_{opt}$), ou éventuellement en commandant un système de refroidissement de la batterie pour abaisser sa température (si elle est élevée, par rapport à la température optimale de fonctionnement $T_{opt}$).

Si le système de stockage 1 comprend plusieurs batteries électriques (par exemple une pour des propulseurs de l'aile gauche, et une autre pour des propulseurs de l'aile droite), le système de traitement et de contrôle 20 peut aussi, lorsque la condition en question est détectée (i.e. : $SOC_a$ faible et $SOC_s$ relativement élevé), commander une modification de répartition, entre ces différentes batteries, d'un courant électrique total à délivrer, afin de diminuer l'intensité du courant i débité par la batterie 10 elle-même (pour pouvoir finalement extraire une charge électrique plus importante de la batterie 10).

Au cours de ce procédé, le système électronique de traitement et de pilotage 20 peut aussi déterminer, sur la base des valeurs d'état de charge $SOC_a$ et $SOC_s$, qu'un changement des paramètres de vol de l'aéronef est souhaitable.

Par exemple, si l'état de charge disponible $SOC_a$ est bas (par exemple inférieur à 20%) alors que l'état de charge stockée $SOC_s$ est assez élevé (par exemple supérieur à 30 ou 40%), le système de traitement et de contrôle 20 peut préconiser un changement d'un ou plusieurs paramètres de vol de l'aéronef, afin de réduire l'intensité du courant débité, pour pouvoir finalement extraire une charge électrique plus importante de la batterie 10.

Lorsque l'état de charge disponible $SOC_a$ et l'état de charge stockée $SOC_s$ ont tous deux des valeurs basses (par exemple inférieures à 10%), le système de traitement et de contrôle 20 peut préconiser l'amorçage d'une phase de descente de l'aéronef, afin qu'il puisse se poser avant que la batterie 10 ne soit complètement vide.

Dans un cas comme dans l'autre, la préconisation de pilotage peut être indiquée au pilote 5 de l'aéronef par l'interface homme-machine 30. Le système de traitement et de contrôle 20 peut aussi commander directement un ou plusieurs actionneurs de l'aéronef (par exemple ses propulseurs, ou des vérins actionnant les gouvernes de profondeur) pour mettre en œuvre directement la préconisation de pilotage en question.

Le procédé en question comprend aussi une étape préliminaire de caractérisation (non représentée) au cours de laquelle les caractéristiques de fonctionnement Caract_Batt de la batterie 10 sont déterminées en effectuant des essais de charge et de décharge sur une batterie de test du même modèle que cette batterie 10, ou sur une cellule de test d'une telle batterie de test.

Par même modèle, on entend une batterie :

- réalisée à partir du même matériau ou ensemble de matériaux de base que pour la batterie 10 (par exemple du plomb, ou du Lithium, ou du Nickel et du Cadmium, ou encore du Zinc et du manganèse),

- utilisant le même type d'anode et de cathode ; par exemple, si la batterie 10 est une batterie au Lithium à anodes en graphite et cathodes en Phosphate de Fer Lithié « LFP », de sera le cas aussi pour la batterie de test ou la cellule de test (et de même si la batterie 10 est une batterie au lithium à anodes Titanate de Lithium « LTO » et à cathodes en Oxyde de Cobalt-Lithium-Manganèse-Nickel « NMC », par exemple),

- et dimensionnées de la même manière que la batterie 10, ou qu'une cellule de cette batterie (mêmes surfaces d'électrodes, même volume de cellule).

Il s'agit par exemple d'une batterie, ou d'une cellule de batterie, fournie par le fabricant de la batterie 10, et pour laquelle le fabricant indique qu'elle est du même modèle (d'ailleurs, la batterie de test pourrait être la batterie 10 elle-même).

Lors de cette étape préliminaire de caractérisation, pour déterminer la charge électrique non extractible $Q_{s,minlim}$ à une température de test donnée, on réalise les opérations suivantes, sur la batterie de test ou sur la cellule de test:

- charge de la batterie ou de la cellule de test, puis

- à ladite température de test $T_T$, et pour un courant de décharge $i_d$ donné, première décharge de la batterie ou de la cellule de test jusqu'à atteindre, aux bornes de la batterie ou de la cellule de test, une tension électrique de seuil de fonctionnement, puis

- modification de la température de la batterie ou de la cellule de test pour l'amener à la température de fonctionnement optimale $T_{opt}$ mentionnée plus haut, puis

- à la température de fonctionnement optimale $T_{opt}$, et pour le courant optimal de décharge $i_{opt}$, deuxième décharge de la batterie ou de la cellule de test, en comptabilisant (par comptage coulométrique) une charge électrique Qr qui est délivrée jusqu'à ce qu'une tension aux bornes de la batterie ou de la cellule de test atteigne ladite tension électrique de seuil de fonctionnement, la charge électrique non extractible $Q_{s,minlim}$ à ladite température de test $T_T$, et pour le décharge $i_d$ mentionné plus haut, étant déterminée à partir de la charge électrique délivrée $Q_r$ comptabilisée lors de cette deuxième décharge.

Lorsque le test est réalisé directement sur une batterie de test de même capacité que la batterie 10 (et pas seulement sur une cellule de test), la charge électrique non extractible $Q_{s,minlim}$ à ladite température de test $T_T$, et pour le décharge $i_d$ est déterminée comme étant égale à la charge électrique délivrée $Q_r$ lors de cette deuxième décharge (puisque cette charge est la charge résiduelle, n'ayant pas été extraite de la batterie lors de la première décharge à la température $T_T$).

Lorsque le test est réalisé sur une cellule de test, de même modèle que l'une des cellules de la batterie 10, la charge électrique non extractible $Q_{s,minlim}$ à ladite température de test $T_T$, et pour la décharge $i_d$ peut par exemple être déterminée comme étant égale à la charge électrique délivrée $Q_r$ lors de la deuxième décharge, multipliée par le nombre de cellules de la batterie 10 (ou, éventuellement, sur la base d'une modélisation électrique plus complète de l'agencement de cellules formant la batterie 10).

La tension électrique de seuil de fonctionnement, en dessous de laquelle on cesse de décharger la batterie, peut-être une tension électrique fixée par les conditions d'utilisation de la batterie 10. Par exemple, s'il s'agit d'une batterie électrique destinée à délivrer une tension de 12V, pour alimenter un certain nombre d'appareils électriques (prévus pour fonctionner sous 12V), cette tension de seuil peut être fixée à 11,5V, ou à 11V, légèrement en dessous de la tension de service prévue.

La tension électrique de seuil de fonctionnement pourrait aussi correspondre à un seuil en dessous duquel une décharge supplémentaire de la batterie pourrait détériorer la batterie (puisque, pour certains types de batteries, une décharge totale, complète de la batterie peut entrainer un vieillissement prématuré de cette batterie).

L'ensemble des opérations présentées ci-dessus, qui permettent de déterminer la charge électrique non extractible Qs,miniim, est exécuté plusieurs fois, pour plusieurs valeurs de la température de test $T_T$, et pour plusieurs valeurs du courant de décharge $i_d$, pour obtenir une cartographie de en fonction de la température et du courant.

La charge maximale atteignable $Q_{s,maxlim}$ peut être déterminée elle aussi lors de cette étape préliminaire de caractérisation, en comptabilisant (par comptage coulométrique), à la température de test, et pour un courant de charge égal, en valeur absolue, à $i_d$, la charge maximale pouvant être emmagasinée dans la batterie de test ou la cellule de test. Cette charge est compatibilisée à partir d'une situation où la batterie ou cellule de test est considérée entièrement déchargée. Pour décharger la batterie entièrement (ou tout au moins, pour la décharger jusqu'à une situation où elle est considérée vide), on la décharge, à la température optimale de fonctionnement $T_{opt}$, et sous le courant $i_{opt}$, jusque ce que la tension à ses bornes atteigne la tension de seuil de fonctionnement mentionnée plus haut.

Différentes variantes peuvent apportées au procédé et au système de stockage qui viennent d'être présentés, en plus de celles déjà mentionnées.

Ainsi, la charge électrique non extractible $Q_{s,minlim}$ et la charge maximale atteignable $Q_{s,maxlim}$, pourraient être déterminées, lors de l'étape S25, en fonction seulement de la température de la batterie, T, au lieu d'être déterminées en tenant compte à la fois de cette température et du courant débité.

Au contraire, d'autres paramètres susceptibles d'influencer ces charges $Q_{s,minlim}$ et $Q_{s,maxlim}$ pourraient être pris en compte, en plus de la température T et du courant i (en particulier lors de l'étape S25). Ainsi, un état de santé SOH (pour « State Of Health » en anglais), représentatif d'un degré de vieillissement plus ou moins important de la batterie 10, pourrait être pris en compte pour estimer ces charges, qui interviennent dans l'estimation de l'état de charge disponible $SOC_a$.

Par ailleurs, ce procédé peut s'appliquer pour surveiller un ensemble de plusieurs batteries. A titre d'illustration, dans le cas de deux batteries B1 et B2, le procédé peut être exécuté de manière similaire (même manière de calculer les charges $Q_s$, $Q_a$, et $Q_{a,max}$, pour chacune des deux batteries), mais en moyennant les charges (pour les deux batteries), ou en prenant, entre les deux batteries, la valeur minimale ou maximale de la charge considérée, selon les besoins d'utilisation, avant de calculer les états de charge globaux.

Ainsi, par exemple, pour deux batteries connectées en série, en cas de décharge, on déterminera un $SOC_a$ global et un $SOC_s$ global, pour l'ensemble de deux batteries, égal respectivement au plus petit des deux $SOC_a$ des deux batteries ($SOC_a$ « individuels »), et au plus petit des deux $SOC_s$ ($SOC_s$ « individuels ») des deux batteries (car c'est la batterie la moins chargée qui va limiter l'opération, lors d'une décharge). De même, pour deux batteries connectées en série, en cas de charge, on déterminera un $SOC_a$ global et un $SOC_s$ global, pour l'ensemble de deux batteries, égal respectivement au plus grand des deux $SOC_a$ des deux batteries, et au plus grand des deux $SOC_s$ des deux batteries (car c'est la batterie la plus chargée qui limitera l'opération de charge).

Enfin, les différentes opérations réalisées lors de ce procédé pourraient être regroupées en étapes, ou organisées différemment, par rapport à ce qui a été présenté plus haut. Ainsi, les charges $Q_a$, $Q_{a,max}$ et l'état de charge disponible $SOC_a$ pourraient être calculés lors d'une même étape, plutôt que lors des deux étapes S25 et S26.

## Revendications

1. Procédé de surveillance d'un niveau de charge d'une batterie (10) d'accumulateurs électriques, le procédé comprenant des étapes de :

   - mesure d'un courant électrique (i) délivré par la batterie (10),
   - mesure d'une température (T) de la batterie (10),
   - (S23) calcul, par un système électronique de traitement et de contrôle (20), d'une charge électrique totale ($Q_s$) emmagasinée dans la batterie (10) à un instant courant (t), par comptage coulométrique, en fonction d'une charge électrique totale emmagasinée dans la batterie à un instant précédent ($Q_{s,o}$) et en fonction du courant électrique (i) mesuré,
   - (S24) calcul d'un état de charge stockée ($SOC_s$), égal à la charge électrique totale ($Q_s$) emmagasinée dans la batterie (10) à l'instant courant, divisée par une charge totale maximale ($Q_{s,max}$) pouvant être emmagasinée dans la batterie, le procédé étant **caractérisé en ce qu'**il comprend de plus les étapes de:

     - (S25) calcul d'une charge électrique disponible ($Q_a$) en fonction d'une différence entre,

       ◦ la charge électrique totale ($Q_s$) emmagasinée dans la batterie à l'instant courant, et
       ◦ une charge électrique non extractible ($Q_{s,minlim}$), ne pouvant pas être extraite de la batterie compte tenu de sa température, la charge électrique non extractible ($Q_{s,minlim}$) étant déterminée en fonction au moins de ladite température (T) mesurée, à partir de caractéristiques de fonctionnement (Caract_Batt) de la batterie stockées dans une mémoire (22) du système électronique de traitement et de contrôle (20),

     - (S26) calcul d'un état de charge disponible ($SOC_a$), égal à la charge électrique disponible ($Q_a$), divisée par une charge disponible maximale ($Q_{a,max}$), la charge disponible maximale ($Q_{a,max}$) étant égale à la différence entre, d'une part, une charge maximale atteignable ($Q_{s,maxlim}$), pouvant être emmagasinée au maximum dans la batterie (10)lorsqu'elle est chargée à ladite température (T), et d'autre part, ladite charge électrique non extractible ($Q_{s,minlim}$).

2. Procédé selon la revendication 1, dans lequel :

   - la charge électrique non extractible ($Q_{s,minlim}$) est déterminée en fonction en outre du courant électrique (i) mesuré, la charge électrique non extractible ($Q_{s,minlim}$) étant une charge électrique ne pouvant pas être extraite de la batterie lorsqu'elle a une température égale à ladite température (T) mesurée et qu'elle délivre un courant égal audit courant électrique (i) mesuré, et dans lequel
   - la charge maximale atteignable ($Q_{s,maxlim}$) est déterminée en fonction de ladite température et du courant électrique (i) mesuré, la charge maximale atteignable ($Q_{s,maxlim}$) étant une charge électrique pouvant être emmagasinée au maximum dans la batterie (10) lorsque la batterie est chargée à une température égale à la température (T) mesurée et avec un courant de charge égal, en valeur absolue, au courant électrique (i) mesuré.

3. Procédé selon l'une des revendications 1 ou 2, comprenant en outre une étape préliminaire de caractérisation de la batterie, au cours de laquelle une partie au moins des caractéristiques de fonctionnement (Caract_Batt) de la batterie (10) sont déterminées en effectuant des essais de charge et de décharge sur une batterie de test du même modèle que ladite batterie (10), ou sur une cellule de test d'une telle batterie de test.

4. Procédé selon la revendication précédente dans lequel, au cours de l'étape préliminaire de caractérisation, pour déterminer la charge électrique non extractible ($Q_{s,minlim}$) à une température de test donnée, on réalise les opérations suivantes, sur la batterie de test ou sur la cellule de test:

- Charge de la batterie ou de la cellule de test, puis
- A ladite température de test, première décharge de la batterie ou de la cellule de test jusqu'à atteindre, aux bornes de la batterie ou de la cellule de test, une tension électrique de seuil de fonctionnement, puis
- Modification de la température de la batterie ou de la cellule de test pour l'amener à une température de fonctionnement optimale ($T_{opt}$), puis
- A la température de fonctionnement optimale ($T_{opt}$), deuxième décharge de la batterie ou de la cellule de test, en comptabilisant la charge électrique (Qr) qui est délivrée jusqu'à ce que la tension aux bornes de la batterie ou de la cellule de test atteigne ladite tension électrique de seuil de fonctionnement, la charge électrique non extractible ($Q_{s,minlim}$) à ladite température de test étant déterminée à partir de la charge électrique délivrée (Qr) comptabilisée lors de cette deuxième décharge.

5. Procédé selon l'une des revendications précédentes dans lequel les caractéristiques de fonctionnement (Caract_Batt) de la batterie (10) comprennent une table de correspondance mettant au moins en correspondance des valeurs de température (T) de la batterie avec des valeurs correspondantes de charge électrique non extractible ($Q_{s,minlim}$), ainsi qu'avec des valeurs correspondantes de charge maximale atteignable ($Q_{s,maxlim}$).

6. Procédé selon l'une des revendications 1 à 5, dans lequel les caractéristiques de fonctionnement (Caract_Batt) de la batterie (10) comprennent une première formule de calcul numérique reliant au moins la charge électrique non extractible ($Q_{s,minlim}$) à la température (T) de la batterie, et une deuxième formule de calcul numérique reliant la charge électrique charge maximale atteignable ($Q_{s,maxlim}$) à la température (T) de la batterie, la première et la deuxième formule étant paramétrées chacune par des coefficients dont les valeurs sont caractéristiques de ladite batterie (10).

7. Procédé selon l'une des revendications précédentes, au cours duquel une interface homme-machine (30) indique ledit état de charge disponible ($SOC_a$) et ledit état de charge stockée ($SOC_s$).

8. Procédé selon la revendication précédente, dans lequel la batterie (10) et le système électronique de traitement et contrôle (20) équipent un véhicule (2), par exemple un aéronef, et dans lequel le système électronique de traitement et de contrôle (20) :

- détermine une préconisation de pilotage en fonction de l'état de charge disponible ($SOC_a$) et de l'état de charge stockée ($SOC_s$), et
- commande à ladite interface homme-machine (30) d'indiquer ladite préconisation de pilotage et/ou commande un ou plusieurs actionneurs du véhicule pour piloter le véhicule (2) conformément à ladite préconisation de pilotage.

9. Procédé selon l'une des revendications précédentes, dans lequel, lorsqu'une condition prédéterminée portant à la fois sur l'état de charge stockée ($SOC_s$) et sur l'état de charge disponible ($SOC_a$) est remplie, le système électronique de traitement et de contrôle (20) commande :

- une modification de température de la batterie (10), et/ou
- une modification d'une répartition, entre plusieurs batteries d'un ensemble de batteries auquel appartient ladite batterie (10), d'un courant électrique total à délivrer.

10. Système (1) de stockage d'électricité comprenant une batterie (10) d'accumulateurs électriques, un capteur de température (12) agencé pour mesurer une température (T) de la batterie, un capteur de courant (11) mesurant le courant électrique (i) délivré par la batterie, et un système électronique de traitement et de contrôle (20) comportant au moins un processeur (21) et une mémoire (22), le système électronique de traitement et de contrôle (20) étant configuré pour exécuter les étapes suivantes :

- calculer une charge électrique totale ($Q_s$) emmagasinée dans la batterie (10) à un instant courant (t), par comptage coulométrique, en fonction d'une charge électrique totale emmagasinée dans la batterie à un instant précédent ($Q_{s,o}$) et en fonction d'un courant électrique (i) mesuré par le capteur de courant (11),

- calculer un état de charge stockée ($SOC_s$), égal à la charge électrique totale ($Q_s$) emmagasinée dans la batterie à l'instant courant, divisée par une charge totale maximale ($Q_{s,max}$) pouvant être emmagasinée dans la batterie (10), le système électronique de traitement et de contrôle étant **caractérisé en ce qu'**il est de plus configuré pour:

- calculer une charge électrique disponible ($Q_a$) en fonction d'une différence entre,

○ la charge électrique totale ($Q_s$) emmagasinée dans la batterie (10) à l'instant courant, et
○ une charge électrique non extractible ($Q_{s,minlim}$), ne pouvant pas être extraite de la batterie compte tenu de sa température (T), la charge électrique non extractible ($Q_{s,minlim}$) étant déterminée en fonction au moins de la température (T) mesurée par ledit capteur de température (12), et à partir de caractéristiques de fonctionnement (Caract_Batt) de la batterie stockées dans la mémoire (22) du système électronique de traitement et de contrôle (20),

- calculer un état de charge disponible ($SOC_a$), égal à ladite charge électrique disponible ($Q_a$), divisée par une charge disponible maximale ($Q_{a,max}$), la charge disponible maximale ($Q_{a,max}$) étant égale à la différence entre, d'une part, une charge maximale atteignable (Qs,maxiim), pouvant être emmagasinée au maximum dans la batterie lorsqu'elle est chargée à ladite température (T), et d'autre part, ladite charge électrique non extractible ($Q_{s,minlim}$).

**11.** Véhicule (2) comprenant un système (1) de stockage d'électricité selon la revendication précédente.

**Patentansprüche**

**1.** Verfahren zum Überwachen eines Ladezustands einer Batterie (10) von elektrischen Akkumulatoren, wobei das Verfahren die folgenden Schritte umfasst:

- Messen eines von der Batterie (10) gelieferten elektrischen Stroms (i),
- Messen einer Temperatur (T) der Batterie (10),
- (S23) Berechnen, durch eine Verarbeitungs- und Steuerelektronik (20), einer elektrischen Gesamtladung ($Q_s$), die in der Batterie (10) zu einem aktuellen Zeitpunkt (t) gespeichert ist, durch coulometrische Zählung, in Abhängigkeit von einer elektrischen Gesamtladung, die in der Batterie zu einem vorhergehenden Zeitpunkt ($Q_{s,o}$) gespeichert war, und in Abhängigkeit von dem gemessenen elektrischen Strom (i),
- (S24) Berechnen eines gespeicherten Ladezustands ($SOC_s$), der gleich der elektrischen Gesamtladung ($Q_s$) ist, die in der Batterie (10) zum aktuellen Zeitpunkt gespeichert ist, geteilt durch eine maximale Gesamtladung ($Q_{s,max}$), die in der Batterie gespeichert werden kann, wobei das Verfahren **dadurch gekennzeichnet ist, dass** es zudem folgende Schritte umfasst:

- (S25) Berechnen einer verfügbaren elektrischen Ladung ($Q_a$) auf der Grundlage einer Differenz zwischen:

○ der elektrischen Gesamtladung ($Q_s$), die zum aktuellen Zeitpunkt in der Batterie gespeichert ist, und
○ einer nicht entnehmbaren elektrischen Ladung ($Q_{s,minlim}$), die aufgrund ihrer Temperatur nicht aus der Batterie entnommen werden kann, wobei die nicht entnehmbare elektrische Ladung ($Q_{s,minlim}$) in Abhängigkeit von mindestens der gemessenen Temperatur (T) anhand von in einem Speicher (22) der Verarbeitungs- und Steuerelektronik (20) gespeicherten Betriebseigenschaften (Caract_Batt) der Batterie bestimmt wird,

- (S26) Berechnen eines verfügbaren Ladezustands ($SOC_a$), der gleich der verfügbaren elektrischen Ladung ($Q_a$) ist, geteilt durch eine maximal verfügbare Ladung ($Q_{a,max}$), wobei die maximal verfügbare Ladung ($Q_{a,max}$) gleich der Differenz ist zwischen, einerseits einer maximal erreichbaren Ladung ($Q_{s,maxlim}$), die maximal in der Batterie (10) gespeichert werden kann, wenn sie bei dieser Temperatur (T) geladen wird, und andererseits der genannten nicht entnehmbaren elektrischen Ladung ($Q_{s,minlim}$).

**2.** Verfahren nach Anspruch 1, bei dem:

- die nicht entnehmbare elektrische Ladung ($Q_{s,minlim}$) zusätzlich in Abhängigkeit von dem gemessenen elektrischen Strom (i) bestimmt wird, wobei die nicht entnehmbare elektrische Ladung ($Q_{s,minlim}$) eine elektrische Ladung ist, die nicht aus der Batterie entnommen werden kann, wenn sie eine Temperatur gleich der gemessenen Temperatur (T) hat und einen Strom gleich dem gemessenen elektrischen Strom (i) abgibt, und bei dem

- die maximal erreichbare Ladung ($Q_{s,maxlim}$) in Abhängigkeit von der Temperatur und dem gemessenen elektrischen Strom (i) bestimmt wird, wobei die maximal erreichbare Ladung ($Q_{s,maxlim}$) eine elektrische Ladung ist, die maximal in der Batterie (10) gespeichert werden kann, wenn die Batterie bei einer Temperatur gleich der gemessenen Temperatur (T) und mit einem Ladestrom gleich dem gemessenen elektrischen Strom (i) als Absolutwert geladen wird.

3. Verfahren nach einem der Ansprüche 1 oder 2, das außerdem einen vorbereitenden Schritt zur Charakterisierung der Batterie umfasst, bei dem zumindest ein Teil der Betriebseigenschaften (Caract_Batt) der Batterie (10) bestimmt wird, indem Lade- und Entladeversuche an einer Testbatterie desselben Modells wie die Batterie (10) oder an einer Testzelle einer solchen Testbatterie durchgeführt werden.

4. Verfahren nach dem vorhergehenden Anspruch, bei dem während des vorbereitenden Schritts der Charakterisierung zur Bestimmung der nicht entnehmbaren elektrischen Ladung ($Q_{s,minlim}$) bei einer gegebenen Testtemperatur die folgenden Vorgänge an der Testbatterie oder der Testzelle durchgeführt werden:

- Laden der Batterie oder der Testzelle, dann
- Bei der gegebenen Testtemperatur erste Entladung der Batterie oder der Testzelle, bis an den Klemmen der Batterie oder der Testzelle eine elektrische Betriebsschwellenspannung erreicht ist, dann
- Ändern der Temperatur der Batterie oder Testzelle, um sie auf eine optimale Betriebstemperatur ($T_{opt}$) zu bringen, dann
- Bei der optimalen Betriebstemperatur ($T_{opt}$) zweite Entladung der Batterie oder der Testzelle, indem die elektrische Ladung (Qr) gezählt wird, die abgegeben wird, bis die Spannung an den Klemmen der Batterie oder der Testzelle die elektrische Betriebsschwellenspannung erreicht, wobei die nicht entnehmbare elektrische Ladung ($Q_{s,minlim}$) bei der Testtemperatur anhand der abgegebenen elektrischen Ladung (Qr) bestimmt wird, die bei dieser zweiten Entladung gezählt wird.

5. Verfahren nach einem der vorhergehenden Ansprüche, bei dem die Betriebseigenschaften (Caract_Batt) der Batterie (10) eine Zuordnungstabelle umfassen, die zumindest die Temperaturwerte (T) der Batterie mit entsprechenden Werten der nicht entnehmbaren elektrischen Ladung ($Q_{s,minlim}$) sowie mit entsprechenden Werten der maximal erreichbaren Ladung ($Q_{(s,maxlim}$) abgleicht.

6. Verfahren nach einem der Ansprüche 1 bis 5, bei dem die Betriebseigenschaften (Caract_Batt) der Batterie (10) eine erste numerische Berechnungsformel umfassen, die mindestens die nicht entnehmbare elektrische Ladung ($Q_{s,minlim}$) mit der Temperatur (T) der Batterie verbindet, und eine zweite numerische Berechnungsformel, die die maximal erreichbare elektrische Ladung ($Q_{s,maxlim}$) mit der Temperatur (T) der Batterie verbindet, wobei die erste und die zweite Formel jeweils durch Koeffizienten parametrisiert werden, deren Werte für die Batterie (10) charakteristisch sind.

7. Verfahren nach einem der vorhergehenden Ansprüche, bei dem eine Mensch-Maschine-Schnittstelle (30) den verfügbaren Ladezustand ($SOC_a$) und den gespeicherten Ladezustand ($SOC_s$) anzeigt.

8. Verfahren nach dem vorhergehenden Anspruch, bei dem die Batterie (10) und die Verarbeitungs- und Steuerelektronik (20) ein Fahrzeug (2), beispielsweise ein Flugzeug, ausstatten und bei dem die Verarbeitungs- und Steuerelektronik (20):

- eine Lenkungsempfehlung in Abhängigkeit vom Zustand der verfügbaren Ladung ($SOC_a$) und vom Zustand der gespeicherten Ladung ($SOC_s$) bestimmt, und
- die Mensch-Maschine-Schnittstelle (30) anweist, die Lenkungsempfehlung anzugeben, und/oder einen oder mehrere Fahrzeugaktuatoren anweist, das Fahrzeug (2) gemäß der Lenkungsempfehlung zu steuern.

9. Verfahren nach einem der vorhergehenden Ansprüche, bei dem, wenn eine vorbestimmte Bedingung erfüllt ist, die sich sowohl auf den gespeicherten Ladezustand ($SOC_s$) als auch auf den verfügbaren Ladezustand ($SOC_a$) bezieht, die Verarbeitungs- und Steuerelektronik (20) steuert:

- eine Änderung der Temperatur der Batterie (10), und/oder
- eine Änderung einer Verteilung eines zu liefernden elektrischen Gesamtstroms auf mehrere Batterien eines Batteriesatzes, zu dem die Batterie (10) gehört.

10. Stromspeichersystem (1) mit einer Batterie (10) aus Akkumulatoren, einem Temperatursensor (12), der so angeordnet ist, dass er eine Temperatur (T) der Batterie misst, einem Stromsensor (11), der den von der Batterie gelieferten elektrischen Strom (i) misst, und einer Verarbeitungs- und Steuerelektronik (20) mit mindestens einem Prozessor (21) und einem Speicher (22), wobei die Verarbeitungs- und Steuerelektronik (20) so konfiguriert ist, dass sie die folgenden Schritte ausführt:

- Berechnen einer in der Batterie (10) gespeicherten elektrischen Gesamtladung ($Q_s$) zu einem aktuellen Zeitpunkt (t) durch coulometrische Zählung in Abhängigkeit von einer in der Batterie zu einem vorherigen Zeitpunkt gespeicherten elektrischen Gesamtladung ($Q_{s,o}$) und in Abhängigkeit von einem vom Stromsensor (11) gemessenen elektrischen Strom (i),
- Berechnen eines gespeicherten Ladezustands ($SOC_s$), der gleich der gesamten elektrischen Ladung ($Q_s$) ist, die zu dem aktuellen Zeitpunkt in der Batterie gespeichert ist, geteilt durch eine maximale Gesamtladung ($Q_{s,max}$), die in der Batterie (10) gespeichert werden kann, wobei die Verarbeitungs- und Steuerelektronik **dadurch gekennzeichnet ist, dass** sie zudem folgende Aufgaben ausführen kann:
- Berechnen einer verfügbaren elektrischen Ladung ($Q_a$) auf der Grundlage einer Differenz zwischen:

  ○ der elektrischen Gesamtladung ($Q_s$), die in der Batterie (10) zum aktuellen Zeitpunkt gespeichert ist, und
  ○ einer nicht entnehmbaren elektrischen Ladung ($Q_{s,minlim}$), die angesichts ihrer Temperatur (T) nicht aus der Batterie entnommen werden kann, wobei die nicht entnehmbare elektrische Ladung ($Q_{s,minlim}$) in Abhängigkeit von mindestens der von dem Temperatursensor (12) gemessenen Temperatur (T) und ausgehend von im Speicher (22) der Verarbeitungs- und Steuerelektronik (20) gespeicherten Betriebseigenschaften (Caract_Batt) der Batterie bestimmt wird,

- Berechnen eines verfügbaren Ladezustands ($SOC_a$), der gleich der verfügbaren elektrischen Ladung ($Q_a$), geteilt durch eine maximal verfügbare Ladung ($Q_{a,max}$) ist, wobei die maximal verfügbare Ladung ($Q_{a,max}$) gleich der Differenz zwischen einerseits einer maximal erreichbaren Ladung ($Q_{s,maxlim}$), die maximal in der Batterie gespeichert werden kann, wenn sie bei der Temperatur (T) geladen wird, und andererseits der nicht entnehmbaren elektrischen Ladung ($Q_{s,minlim}$) ist.

11. Fahrzeug (2) mit einem Stromspeichersystem (1) nach dem vorhergehenden Anspruch.

## Claims

1. A method for monitoring a charge level of an electrical storage battery (10), the method comprising the steps of:

   - measuring an electric current (i) delivered by the battery (10),
   - measuring a temperature (T) of the battery (10),
   - (S23) calculating, by an electronic processing and control system (20), a total electrical charge ($Q_s$) accumulated in the battery (10) at a current instant (t), by Coulomb counting, as a function of a total electrical charge accumulated in the battery at a previous instant ($Q_{s,o}$) and as a function of the electrical current (i) measured,
   - (S24) calculating a stored state of charge ($SOC_s$), equal to the total electrical charge ($Q_s$) accumulated in the battery (10) at the current instant, divided by a maximum total charge ($Q_{s,max}$) that can be stored in the battery,

   the method being **characterised in that** it comprises further the steps of :

   - (S25) calculating an available electrical charge ($Q_a$) as a function of a difference between,

     ○ the total electrical charge ($Q_s$) accumulated in the battery at the current instant, and
     ○ a non-extractable electrical charge ($Q_{s,minlim}$), which cannot be extracted from the battery given its temperature, the non-extractable electrical charge ($Q_{s,minlim}$) being determined as a function of at least said measured temperature (T), from operating characteristics (Caract_Batt) of the battery stored in a memory (22) of the electronic processing and control system (20),

- (S26) calculating an available state of charge ($SOC_a$), equal to the available electrical charge ($Q_a$), divided by a maximum available charge ($Q_{a,max}$), the maximum available charge ($Q_{a,max}$) being equal to the difference between, on the one hand, a maximum achievable charge ($Q_{s,maxlim}$), which can be accumulated at most in the battery (10) when it is charged at said temperature (T), and, on the other hand, said non-extractable electrical charge ($Q_{s,minlim}$).

2. The method according to claim 1, wherein:

   - the non-extractable electric charge ($Qs_{,minlim}$) is further determined as a function of the electric current (i) measured, the non-extractable electric charge ($Qs_{,minlim}$) being an electric charge which cannot be extracted from the battery when it has a temperature equal to said temperature (T) measured and delivers a current equal to said electric current (i) measured, and wherein
   - the maximum achievable charge ($Q_{s,maxlim}$) is determined as a function of said temperature and the electrical current (i) measured, the maximum achievable charge ($Q_{s,maxlim}$) being an electrical charge that can be accumulated at most in the battery (10) when the battery is charged at a temperature equal to the temperature (T) measured and with a charge current equal, in absolute value, to the electrical current (i) measured.

3. The method according one of claims 1 or 2, further comprising a preliminary step of characterising the battery, during which at least some of the operating characteristics (Caract_Batt) of the battery (10) are determined by carrying out charge and discharge tests on a test battery of the same model as said battery (10), or on a test cell of such a test battery.

4. The method according to the preceding claim wherein, during the preliminary characterisation step, in order to determine the non-extractable electrical charge ($Q_{s,minlim}$) at a given test temperature, the following operations are carried out on the test battery or on the test cell:

   - Charging the battery or test cell, and then
   - At said test temperature, firstly discharging the battery or test cell until an electrical operating threshold voltage is reached across the battery or test cell, and then
   - Modifying the temperature of the battery or test cell to bring it to the optimum operating temperature ($T_{opt}$), and then
   - At the optimum operating temperature ($T_{opt}$), secondly discharging the battery or test cell, by counting the electrical charge (Qr) which is delivered until the voltage across the battery or test cell reaches said operating threshold voltage, the non-extractable electrical charge ($Q_{s,minlim}$) at said test temperature being determined from the delivered electrical charge (Qr) counted during this second discharge.

5. The method according to one of the preceding claims, wherein the operating characteristics (Caract_Batt) of the battery (10) comprise a mapping table mapping at least temperature values (T) of the battery to corresponding non-extractable electrical charge values ($Q_{s,minlim}$), as well as to corresponding maximum achievable charge values ($Q_{s,maxlim}$).

6. The method according to one of claims 1 to 5, wherein the operating characteristics (Caract_Batt) of the battery (10) comprise a first numerical calculation formula relating at least the non-extractable electrical charge ($Q_{s,minlim}$) to the temperature (T) of the battery, and a second numerical calculation formula relating the maximum achievable electrical charge ($Q_{s,maxlim}$) to the temperature (T) of the battery, the first and second formulae each being parameterised by coefficients whose values are characteristic of said battery (10).

7. The method according to one of the preceding claims, during which a man-machine interface (30) indicates said available state of charge ($SOC_a$) and said stored state of charge ($SOC_s$).

8. The method according to the preceding claim, wherein the battery (10) and the electronic processing and control system (20) equip a vehicle (2), for example an aircraft, and wherein the electronic processing and control system (20):

   - determines a piloting recommendation as a function of the available state of charge ($SOC_a$) and the stored state of charge ($SOC_s$), and
   - orders said man-machine interface (30) to indicate said piloting recommendation and/or orders one or more vehicle actuators to pilot the vehicle (2) in accordance with said piloting recommendation.

9. The method according to one of the preceding claims, wherein, when a predetermined condition relating both to the stored charge state ($SOC_s$) and to the available charge state ($SOC_a$) is met, the electronic processing and control system (20) orders:

   - a modification in the temperature of the battery (10), and/or
   - a modification in a distribution, between several batteries of a set of batteries to which said battery (10) belongs, of a total electric current to be delivered.

10. An electricity storage system (1) comprising an electrical storage battery (10), a temperature sensor (12) arranged to measure a temperature (T) of the battery, a current sensor (11) measuring the electrical current (i) delivered by the battery, and an electronic processing and control system (20) including at least a processor (21) and a memory (22), the electronic processing and control system (20) being configured to perform the following steps of:

   - calculating a total electrical charge ($Q_s$) accumulated in the battery (10) at a current instant (t), by Coulomb counting, as a function of a total electrical charge accumulated in the battery at a previous instant ($Q_{s,o}$) and as a function of an electrical current (i) measured by the current sensor (11),
   - calculating a stored state of charge ($SOC_s$), equal to the total electrical charge ($Q_s$) accumulated in the battery at the current instant, divided by a maximum total charge ($Q_{s,max}$) that can be accumulated in the battery (10),

   the electronic processing and control system being **characterised in that** it is further configured for :

   - calculating an available electrical charge ($Q_a$) as a function of the difference between,

       ○ the total electrical charge ($Q_s$) accumulated in the battery (10) at the current instant, and
       ○ a non-extractable electrical charge ($Q_{s,minlim}$), which cannot be extracted from the battery given its temperature (T), the non-extractable electrical charge ($Q_{s,minlim}$) being determined as a function of at least the temperature (T) measured by said temperature sensor (12), and from operating characteristics (Caract_Batt) of the battery stored in the memory (22) of the electronic processing and control system (20),

   - calculating an available state of charge ($SOC_a$), equal to said available electrical charge ($Q_a$), divided by a maximum available charge ($Q_{a,max}$), the maximum available charge ($Q_{a,max}$) being equal to the difference between, on the one hand, a maximum achievable charge ($Q_{s,maxlim}$), which can be accumulated at most in the battery when it is charged at said temperature (T), and, on the other hand, said non-extractable electrical charge ($Q_{s,minlim}$).

11. A vehicle (2) comprising an electricity storage system (1) according to the preceding claim.

# Fig. 1

# Fig. 2

# Fig. 3

# Fig. 4

**EP 4 396 594 B1**

## RÉFÉRENCES CITÉES DANS LA DESCRIPTION

**Documents brevets cités dans la description**

- US 6534954 B

- US 2015046108 A1